(19) Europäisches Patentamt
European Patent Office
Office européen des brevets

(11) **EP 3 594 702 B1**

(12) **EUROPÄISCHE PATENTSCHRIFT**

(45) Veröffentlichungstag und Bekanntmachung des Hinweises auf die Patenterteilung:
**06.07.2022 Patentblatt 2022/27**

(51) Internationale Patentklassifikation (IPC):
*G01R 27/16* *(2006.01)*   *G01R 27/26* *(2006.01)*
*G01R 31/58* *(2020.01)*   *G01R 31/62* *(2020.01)*

(21) Anmeldenummer: **18183055.5**

(22) Anmeldetag: **12.07.2018**

(52) Gemeinsame Patentklassifikation (CPC):
**G01R 27/2611; G01R 27/16; G01R 27/2605;
G01R 31/58; G01R 31/62**

(54) **VERFAHREN UND VORRICHTUNG ZUR ERMITTLUNG VON PARAMETERN EINER PRIMÄRKOMPONENTE EINES ELEKTRISCHEN ENERGIEVERSORGUNGSNETZES**

METHOD AND APPARATUS FOR DETERMINATION OF PARAMETERS OF A PRIMARY COMPONENT OF AN ELECTRICAL POWER SUPPLY NETWORK

PROCÉDÉ ET DISPOSITIF DE DÉTERMINATION DE PARAMÈTRES D'UN COMPOSANT PRIMAIRE D'UN RÉSEAU D'ALIMENTATION EN ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.01.2020 Patentblatt 2020/03**

(73) Patentinhaber: **Siemens Aktiengesellschaft
80333 München (DE)**

(72) Erfinder:
• **Fröhner, Wiebke
92224 Amberg (DE)**
• **Mladenovic, Ivana
90556 Seukendorf (DE)**
• **Werner, Thomas
91126 Rednitzhembach (DE)**

(56) Entgegenhaltungen:
**WO-A1-2010/057516   DE-A1- 10 253 865**

**Beschreibung**

Die Erfindung betrifft ein Verfahren zur Ermittlung von Parametern einer Primärkomponente eines elektrischen Energieversorgungsnetzes, wobei die Parameter elektrische und/oder physikalische Eigenschaften der Primärkomponente angeben. Bei dem Verfahren werden eingangsseitige Strom- und Spannungswerte am Eingang der Primärkomponente und ausgangsseitige Strom und Spannungswerte am Ausgang der Primärkomponente erfasst, und es werden Parameter anhand der eingangsseitigen und der ausgangsseitigen Strom und Spannungswerte und einer für die Primärkomponente spezifischen Modellbeschreibung, die unter Verwendung der Parameter der Primärkomponente mathematisch eine Abhängigkeit der ausgangsseitigen Strom und Spannungswerte von den eingangsseitigen Strom und Spannungswerten beschreibt, ermittelt. Die Erfindung betrifft auch eine Vorrichtung zur Durchführung dieses Verfahrens.

Elektrische Primärkomponenten in Energieversorgungsnetzen, wie beispielsweise Transformatoren, Kabel oder Leitungen, sind durch elektrische Belastungen (z.B. hohe Spannungen und Ströme, Fehlerzustände) im Betrieb aber auch durch äußere Einflüsse (wie mechanische Belastungen, Temperaturschwankungen, extreme Temperaturen, Sonneneinstrahlung, Feuchtigkeit, Frost und ähnliche Einflüsse) einem beständigen Alterungsprozess unterworfen und müssen zur Vorsorge regelmäßig überprüft, gewartet und ausgetauscht werden, um den ordnungsgemäßen Betrieb des Energieversorgungsnetzes zu gewährleisten.

In heutigen elektrischen Energieversorgungsnetzen ist die automatische Überwachung des Alterungszustandes einer elektrischen Primärkomponente sehr aufwendig und teuer. Aus diesem Grund werden im Allgemeinen nur sehr große und/oder sehr hochwertige Primärkomponenten, wie zum Beispiel Transformatoren in Hochspannungsnetzen, mit entsprechenden Sensoren und Auswertesystemen ausgerüstet, die in Echtzeit eine Überwachung und Diagnose des Alterungszustandes erlauben. Häufig wird dabei auch nicht die gesamte Primärkomponente betrachtet, sondern es werden nur ausgewählte Komponenten überwacht.

Während in Hochspannungs-Übertragungsnetzen eine automatische Überwachung und Diagnose von Primärkomponenten daher noch vergleichsweise häufig stattfindet, ist in Verteilnetzen der Mittel- und Niederspannungsebene eine online-Überwachung, also eine Überwachung während des laufenden Betriebs, dagegen aus Kostengründen eher unüblich. Wenige ausgesuchte Primärkomponenten werden dort mit Hilfe von speziellen Diagnosesystemen untersucht, wobei sie für die Untersuchung aus dem Betrieb genommen werden müssen. Für die diagnostische Zwecke wurden unterschiedliche Methoden entwickelt, die für spezifische Primärkomponenten jeweils am besten geeignet sind. Diese basieren meistens auf offline durchgeführten Messungen, d.h. im Feld befindliche und zu diagnostizierende Primärkomponenten werden hierfür zuerst aus dem Betrieb genommen.

Die wenigen online durchführbaren diagnostischen Methoden sind zudem spezifisch für die Primärkomponenten. Ein Beispiel dafür sind Teilentladungsmessungen, mit denen Schwachstellen in Isolationsmedien identifiziert werden sollen. Ein Beispiel einer Methode zur Bestimmung des Alterungszustandes von Primärkomponenten wie Transformatoren oder Generatoren ist aus der EP 1623240 A2 bekannt.

Eine weitere Möglichkeit für eine online durchführbare Diagnose besteht in einer Verlustfaktormessung. Beispielhaft sei die WO 2012/162486 A2 genannt, die eine online durchführbare Überwachung des Alterungszustands eines Kabels beschreibt, wobei allerdings eine aufwändige Messtechnik erforderlich ist, um eine Zeitsynchronität der Messungen an verschiedenen Leitungsenden zu ermöglichen. Bei dem bekannten Verfahren wird die Synchronisation mittels eines Synchronisierungsgerätes mit Satellit-Uhren, die eine Genauigkeit von maximal ±40ns aufweisen, erreicht. Zudem erfordert diese Lösung einen hohen Kommunikationsaufwand zwischen den zur Messung eingesetzten Detektoren und einer zentralen Auswerteeinheit.

Im Allgemeinen lassen sich elektrische Primärkomponenten in einem Energieversorgungsnetz durch ein Ersatzschaltbild beschreiben, mit dem die wesentlichen Eigenschaften auf konzentrierte elektrische Elemente abgebildet werden. Beispielsweise werden Transformatoren durch das sogenannte T-Ersatzschaltbild beschrieben, bei dem dieses Ersatzschaltbild Elemente wie Eisen- und Kupferverluste als auch die Hauptfeldinduktivität darstellt.

Die Parameter dieser Elemente ändern sich während der Lebenszeit der Primärkomponente und geben damit Hinweise auf den Zustand des Betriebsmittels. Es wäre daher wünschenswert, diese Parameter bzw. deren Änderungen im Betrieb zu erfassen und auswerten zu können. Prinzipiell können mit externen Strom- und Spannungsmessungen diese Parameter berechnet werden.

Für den Fall einer Primärkomponente in Form einer elektrischen Energieversorgungsleitung ist es beispielsweise aus dem Artikel "An Application of Synchronous Phasor Measurement to the Estimation of the Parameters of an Overhead Transmission Line", L. Phillipot, J.C. Maun, Electrical Engineering Department, Free University of Brussels, 1995, bekannt, anhand von Messungen sogenannter Phasoren Parameter wie Impedanzen und Admittanzen einer Leitung zu ermitteln. Eine Alternative dazu ist im Artikel "Calculation of Transmission Line Parameters from Synchronized Measurements", R. E. Wilson, G. A. Zevenbergen, D.L. Mah, A. J. Murphy, Electric Machines and Power Systems, 1999, dargestellt.

Allerdings führen die unvermeidlichen Messfehler der Messgeräte dazu, dass die mathematisch korrekten Gleichung der Ersatzschaltbilder entweder nicht gelöst werden können oder dass sich Messfehler in den Parameterberechnungen fortpflanzen.

Ein weiteres Beispiel aus dem Stand der Technik ist in DE10253865A1 offenbart.

In anderen Technologiebereichen werden mathematische Verfahren eingesetzt, um aus einer größeren Anzahl von Messwerten Parameter des technischen Modells zu bestimmen. Dazu werden die mathematischen Modellgleichungen des technischen Problems aufgestellt und die Parameter mit Hilfe von numerischen Optimierungserfahren (z.B. Gauß-Newton, Levenberg-Marquardt, Lagrange-Relaxation) durch Minimierung der Fehlerquadrate bestimmt.

Die Methoden erfordern es im Allgemeinen, die mathematischen Modellgleichungen zumindest um den Arbeitspunkt zu linearisieren bzw. zu differenzieren, damit sie in die für das numerische Verfahren erforderliche Form gebracht werden. Damit sind die mathematischen Formulierungen nicht nur spezifisch für den jeweiligen Anwendungsfall, sondern auch spezifisch für die konkrete mathematische Modellbildung.

Es wäre daher wünschenswert, auch in Verteilnetzen den Alterungszustand der Primärkomponenten genauer zu kennen, um Wartungs- und Instandhaltungsmaßnahmen optimal planen zu können. Zusätzlich wäre es vorteilhaft, diese Zustände ohne Unterbrechung des Betriebes ermitteln zu können.

Aufgabe der Erfindung , die durch die unabhängigen Ansprüche definiert ist, ist damit, eine ohne Unterbrechung des Betriebsablaufs einer Primärkomponente durchführbare und vergleichsweise genaue und gegen Messfehler unempfindliche Möglichkeit zur Ermittlung eines Alterungszustands einer Primärkomponente anzugeben.

Hinsichtlich des erfindungsgemäßen Verfahrens wird diese Aufgabe durch ein Verfahren der eingangs angegebenen Art gelöst, bei dem die folgenden weiteren Schritte durchgeführt werden:

a) Startwerte der Parameter werden als Eingangswerte zur Ermittlung einer Menge von abgeleiteten Werten der Parameter verwendet;

b) unter Verwendung der eingangsseitigen und der ausgangsseitigen Strom- und Spannungswerte wird aus der Menge von abgeleiteten Werten der Parameter eine Untermenge solcher abgeleiteter Werte der Parameter ausgesucht, mit denen die Modellbeschreibung mit einer hohen Güte die Abhängigkeit der ausgangsseitigen Strom- und Spannungswerte von den eingangsseitigen Strom- und Spannungswerten beschreibt;

c) unter Verwendung der Untermenge der abgeleiteten Werte der Parameter als Eingangswerte wird eine neue Menge von abgeleiteten Werten der Parameter ermittelt;

d) unter Verwendung der neuen Menge von abgeleiteten Werten der Parameter werden die Schritte b) und c) so lange durchgeführt, bis ein Abbruchkriterium hinsichtlich der Güte der ermittelten abgeleiteten Werte der Parameter erfüllt ist.

Mit dem erfindungsgemäßen Verfahren können vorteilhaft aus den durch Messung erfassten Strom- und Spannungswerten an beiden Enden der Primärkomponente und durch iterative Anpassung einer für die Primärkomponente spezifischen Modellbeschreibung die die elektrischen Eigenschaften der Primärkomponente (z.B. Impedanzen, Admittanzen, Kapazitäten, Induktivitäten sowie physikalisch damit zusammenhängende Werte wie z.B. materialspezifische Größen) angebenden Parameter ermittelt werden. Die Messung kann während des laufenden Betriebs der Primärkomponente durchgeführt werden. Aufgrund der iterativen Vorgehensweise kann eine hohe Güte in Form einer großen Genauigkeit bei der Ermittlung der Parameter erreicht werden.

Eine vorteilhafte Ausführungsform des erfindungsgemäßen Verfahrens sieht vor, dass als Startwerte solche Werte der Parameter verwendet werden, die elektrische Eigenschaften der Primärkomponente in einem unbenutzten Zustand angeben. Ausgehend von diesen Werten verändern sich im Laufe der Lebenszeit der Primärkomponente die Parameter und lassen einen Rückschluss auf die Alterung der Primärkomponente zu.

Solche Werte werden üblicherweise herstellerseitig bei der Auslieferung der Primärkomponente angegeben und beispielsweise auf einem Typenschild oder in technischen Beschreibungen der Primärkomponente vermerkt.

Alternativ dazu kann auch vorgesehen sein, dass als Startwerte solche Werte der Parameter verwendet werden, die elektrische Eigenschaften der Primärkomponente in einem benutzten Zustand angeben. Ausgehend von diesen Werten verändern sich im Laufe der weiteren Lebenszeit einer benutzten Primärkomponente die Parameter weiter und lassen einen Rückschluss auf die weitere Alterung der Primärkomponente zu.

Zur Ermittlung der elektrischen Eigenschaften der benutzten Primärkomponente können geeignete Messverfahren, wie beispielsweise ein off-line Diagnoseverfahren eingesetzt werden. Hierdurch kann der Fall berücksichtigt werden, bei dem die Primärkomponente bereits seit einiger Zeit in Betrieb ist und die benötigten Parameter aus einem Diagnoseverfahren bekannt sind.

Gemäß dem erfindungsgemäßen Verfahren ist vorgesehen, dass zur Ermittlung der abgeleiteten Werte der Parameter eine Rekombination und/oder Mutation der jeweiligen Eingangswerte durchgeführt wird.

Als Rekombination und Mutation werden Funktionen zur Bildung abgeleiteter Werte bezeichnet, die ihren Ursprung in der Optimierung mittels Evolutionsstrategien haben. Beispielsweise können mittels einer Rekombination in Form einer Mittelwertbildung, einer Maximalwert- oder einer Minimalwertbildung aus mehreren Werten abgeleitete Werte gebildet werden. Ein Beispiel für eine Mutation ist die Bildung eines abgeleiteten Wertes durch Multiplikation eines Wertes mit einer Zufallszahl.

Gemäß einer weiteren vorteilhaften Ausführungsform ist vorgesehen, dass zur Ermittlung der Untermenge der abgeleiteten Werte der Parameter diejenigen abgeleiteten Werte der Parameter ausgewählt werden, für die eine Differenz zwischen mittels der Modellbeschreibung aus den eingangsseitigen Strom- und Spannungswerten berechneten ausgangsseitigen Strom- und Spannungswerten und den durch Messung erfassten ausgangsseitigen Strom- und Spannungswerten einen ersten Schwellenwert unterschreitet.

Mit anderen Worten wird in diesem Selektionsschritt die Untermenge gebildet wird, indem aus der Menge der abgeleiteten Parameter die hinsichtlich der Optimierung besten ausgewählt werden. Somit können für den nächsten Durchgang diejenigen abgeleiteten Werte ausgewählt werden, mit denen sich das tatsächliche Verhalten der Primärkomponente am besten beschreiben lässt. Hierzu kann beispielsweise die Methode der kleinsten Fehlerquadrate eingesetzt werden.

Die iterative Vorgehensweise endet mit Ermittlung der für die Primärkomponente letztlich gültigen Parameter. In diesem Zusammenhang kann gemäß einer weiteren vorteilhaften Ausführungsform des erfindungsgemäßen Verfahrens vorgesehen sein, dass das Abbruchkriterium entweder nach Durchlauf einer vorgegebenen Anzahl von Iterationen der Schritte b) und c) oder für solche Werte von Parametern erfüllt ist, für die eine Verbesserung der Güte der aktuellen abgeleiteten Werte der Parameter bezüglich der Güte der vorherigen Werte von Parametern einen zweiten Schwellenwert unterschreitet.

Um das Verfahren besonders unempfindlich gegenüber ungenauen oder fehlerhaften Messungen auszuführen wird gemäß einer weiteren vorteilhaften Ausführungsform vorgeschlagen, dass das Verfahren für eine Vielzahl von eingangsseitigen und ausgangsseitigen Strom- und Spannungswerten durchgeführt wird, und als Parameter der Primärkomponente solche Parameter verwendet werden, bei denen das Abbruchkriterium unter Betrachtung aller eingangsseitiger und ausgangsseitiger Strom- und Spannungswerte erfüllt ist.

Durch die Verwendung einer Vielzahl von eingangs- und ausgangsseitigen Strom- und Spannungswerten kann eine Unabhängigkeit der Ermittlung der Parameter von einzelnen wenigen - und ggf. fehlerbehafteten - Strom- und Spannungswerten erreicht werden. Durch die große Menge an für die Parameterermittlung verwendeten Strom- und Spannungswerten können nämlich etwaige Ungenauigkeiten oder Fehler, die in der Messung selbst begründet sind, verringert werden.

Schließlich sieht eine weitere vorteilhafte Ausführungsform des erfindungsgemäßen Verfahrens vor, dass das Verfahren wiederholt durchgeführt wird und ein Verlauf der ermittelten Parameter der Primärkomponente zur Ermittlung eines Alterungszustands der Primärkomponente betrachtet wird.

Auf diese Weise können nämlich leicht schleichende oder sprunghafte Veränderungen einzelner oder mehrerer Parameter erkannt werden. Durch Vergleich mit geeigneten Schwellenwerten können Aussagen über die Alterung der Primärkomponente getroffen werden. Beispielsweise können auf diese Weise Wartungs- oder Austauschmaßnahmen genau dann ausgelöst werden, wenn die Notwendigkeit dafür besteht.

Die oben genannte Aufgabe wird auch durch eine Vorrichtung zur Ermittlung von Parametern einer Primärkomponente eines elektrischen Energieversorgungsnetzes, wobei die Parameter elektrische und/oder physikalische Eigenschaften der Primärkomponente angeben gelöst. Die Vorrichtung ist zur Durchführung der folgenden Schritte ausgebildet:

- Erfassen von eingangsseitigen Strom- und Spannungswerten am Eingang der Primärkomponente;

- Erfassen von ausgangsseitigen Strom- und Spannungswerten am Ausgang der Primärkomponente; und

- Ermitteln der Parameter anhand der eingangsseitigen und der ausgangsseitigen Strom- und Spannungswerte und einer für die Primärkomponente spezifischen Modellbeschreibung, die unter Verwendung der Parameter der Primärkomponente mathematisch eine Abhängigkeit der ausgangsseitigen Strom- und Spannungswerte von den eingangsseitigen Strom- und Spannungswerten beschreibt.

Erfindungsgemäß ist vorgesehen, dass die Vorrichtung zur Durchführung der folgenden weiteren Schritte ausgebildet ist:

a) Startwerte der Parameter werden als Eingangswerte zur Ermittlung einer Menge von abgeleiteten Werten der Parameter verwendet;

b) unter Verwendung der eingangsseitigen und der ausgangsseitigen Strom- und Spannungswerte wird aus der Menge von abgeleiteten Werten der Parameter eine Untermenge solcher abgeleiteter Werte der Parameter ausgesucht, mit denen die Modellbeschreibung mit einer hohen Güte die Abhängigkeit der ausgangsseitigen Strom- und Spannungswerte von den eingangsseitigen Strom- und Spannungswerten beschreibt;

c) unter Verwendung der Untermenge der abgeleiteten Werte der Parameter als Eingangswerte wird eine neue Menge von abgeleiteten Werten der Parameter ermittelt;

d) unter Verwendung der neuen Menge von abgeleiteten Werten der Parameter werden die Schritte b) und c) so lange durchgeführt, bis ein Abbruchkriterium hinsichtlich der Güte der ermittelten abgeleiteten Werte der Parameter erfüllt ist.

Bei der Vorrichtung kann es sich z.B. um eine Datenverarbeitungseinrichtung in einer Schaltstation oder einer Netzleitstelle des elektrischen Energieversorgungsnetzes sowie um ein Fernwirkgerät oder ein Schutzgerät einer Energieautomatisierungsanlage handeln. Außerdem kann es sich bei der Vorrichtung auch um eine Datenverarbeitungseinrichtung eines verteilten Computersystems, insbesondere eines Cloud-Computersystems handeln.

Hinsichtlich der erfindungsgemäßen Vorrichtung gelten alle zu dem erfindungsgemäßen Verfahren voranstehend und nachfolgend gemachten Ausführungen und umgekehrt in entsprechender Weise, insbesondere ist die erfindungsgemäße Vorrichtung zur Durchführung des erfindungsgemäßen Verfahrens eingerichtet. Auch hinsichtlich der Vorteile der erfindungsgemäßen Vorrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Vorrichtung in keiner Weise einschränkend zu verstehen.

Hierzu zeigen

Figur 1 ein Ausführungsbeispiel einer Vorrichtung zur Ermittlung von Parametern einer Primärkomponente;

Figur 2 ein beispielhaftes Ersatzschaltbild zur Erläuterung einer Modellbeschreibung einer Primärkomponente; und

Figur 3 ein schematisches Ablaufdiagramm zur Erläuterung eines Ausführungsbeispiels eines Verfahrens zur Ermittlung von Parametern einer Primärkomponente.

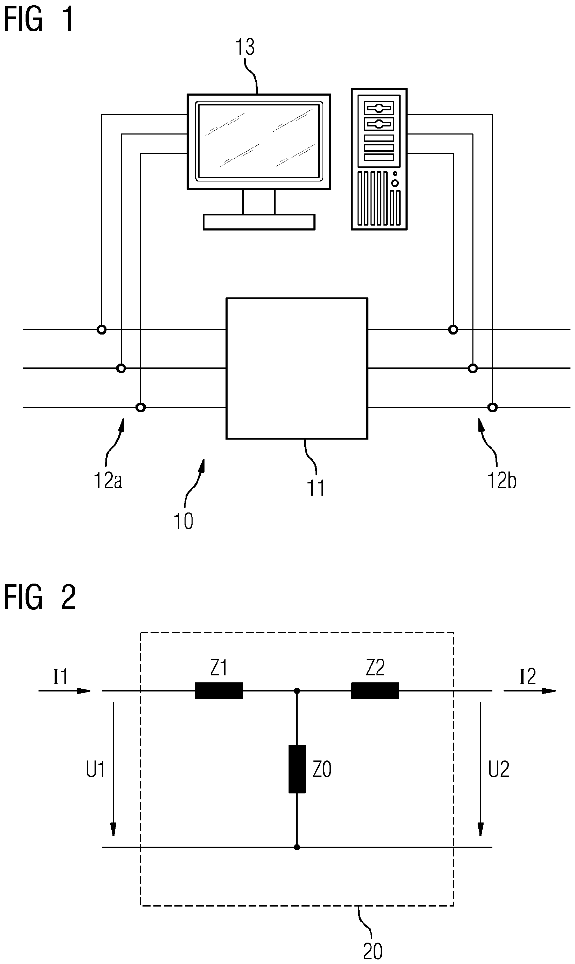

Figur 1 zeigt in schematischer Darstellung eine Vorrichtung 10, mit der Parameter einer elektrischen Primärkomponente 11, z.B. eines Transformators, in einem nicht weiter dargestellten elektrischen Energieversorgungsnetz ermittelt werden können. Die Parameter beschreiben hierbei elektrische Eigenschaften der Primärkomponente, wie beispielsweise Impedanzen, Admittanzen, Induktivitäten, Kapazitäten und physikalisch damit verbundene Werte. Durch Auswertung einer Veränderung der Parameter kann eine Aussage über einen Alterungszustand der Primärkomponente getroffen werden.

Hierzu sind zwei Messstellen 12a und 12b vorgesehen, an denen mit lediglich schematisch angedeuteten Messaufnehmern, z.B. Strom- und Spannungswandlern, Signale elektrischer Messgrößen, z.B. Ströme und Spannungen, erfasst werden. Konkret werden an einer am Eingang der Primärkomponente 11 liegenden Messstelle 12a eingangsseitige Strom- und Spannungswerte und an einer am Ausgang der Primärkomponente 11 liegenden Messstelle 12b ausgangsseitige Strom- und Spannungswerte aufgenommen. Die Signale werden daraufhin einer Vorrichtung 13 in Form einer Datenverarbeitungseinrichtung zugeführt, mit der die Ermittlung der Parameter der Primärkomponente 11 durchgeführt wird. Bei der Datenverarbeitungseinrichtung kann es sich beispielsweise um einen Rechner in einer Schaltstation oder in einer Netzleitstelle sowie um ein Fernwirkgerät oder ein Schutzgerät einer Energieautomatisierungsanlage handeln. Außerdem kann die Datenverarbeitungseinrichtung auch als verteiltes Rechnersystem, insbesondere als Cloud-Computersystem ausgebildet sein.

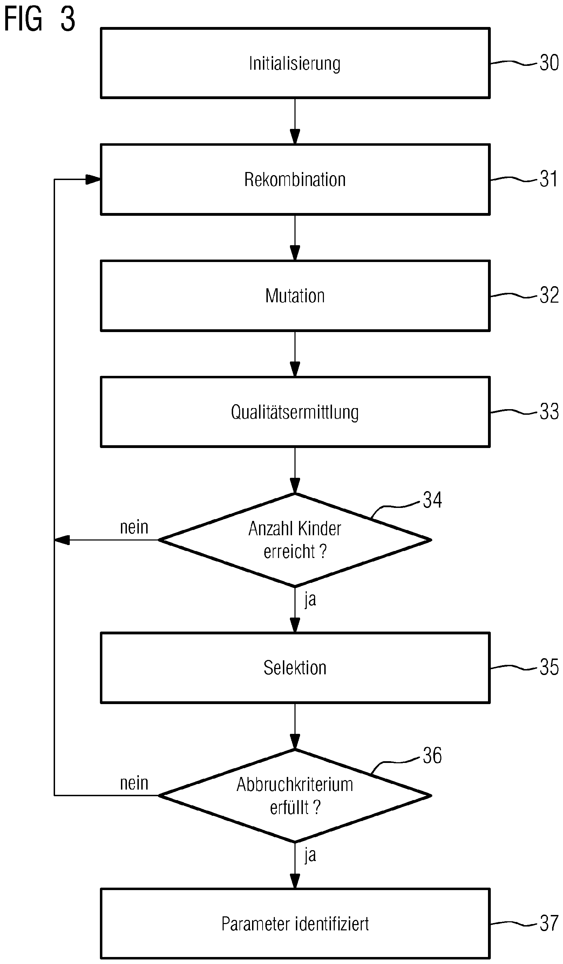

Die Vorgehensweise bei der Ermittlung der Parameter der Primärkomponente 11 wird nachfolgend anhand der Figuren 2 und 3 näher erläutert.

Zur Ermittlung der Parameter wird ein iteratives Verfahren in Form eines sogenannten evolutionären Algorithmus, z.B. eine Evolutionsstrategie, eingesetzt. Hierdurch können die Parameter einer elektrischen Primärkomponente anhand einer größeren Anzahl von ggf. fehlerbehafteten Messwerten identifiziert werden. Dazu wird zunächst ein elektrisches Ersatzschaltbild der Primärkomponente gebildet, um damit eine mathematische Modellbeschreibung der Primärkomponente zu ermitteln. Für den Fall, dass es sich bei der Primärkomponente um einen Transformator handelt, wird das Ersatzschaltbild beispielsweise als sogenanntes "T-Ersatzschaltbild" erzeugt, wie es in Figur 2 schematisch dargestellt ist. Der Inhalt des gestrichelt gezeichneten Kastens (sogenannter "Vierpol" 20) stellt hierbei grafisch die Modellbeschreibung des Transformators mit seinen Parametern in Form der Impedanzen Z1, Z2 und Z0 dar. Eingangsseitige Strom- und Spannungswerte sind als I1 und U1, ausgangsseitige Strom- und Spannungswerte als I2 und U2 bezeichnet.

Im Rahmen des Verfahrens werden für die konkrete Primärkomponente 11 eine Vielzahl von zueinander gehörenden Strom- und Spannungsmessungen erzeugt, die das Verhalten des allgemeinen Vierpols 20 beschreiben.

Mit Hilfe der für das Ersatzschaltbild gültigen Kirchhoffschen Knoten- und Maschengleichungen lassen sich die physikalischen Zusammenhänge zwischen den Strom- und Spannungsmessungen und den gesuchten Parametern, in diesem Fall die Impedanzen Z0, Z1 und Z2 bestimmen.

Dabei ist anzumerken, dass die Formulierungen für das vorgeschlagene Verfahren keiner direkten Vorgabe folgen müssen, zum Beispiel stückweise Linearität oder die Darstellungen als Polynom n-ter Ordnung. Sie können so gewählt werden, wie die technisch-physikalischen Gleichungen es tatsächlich angeben.

Durch Anwendung der Knoten- und Maschenregeln erhält man für den Fall der Figur 2 das folgende Gleichungssystem, mit dem sich die in diesem Fall die Modellbeschreibung der Primärkomponente darstellen lässt:

$$\left(\underline{I_1} - \underline{I_2}\right) \cdot \underline{Z_0} + \underline{I_1} \cdot \underline{Z_1} = \underline{U_1}$$

$$\left(\underline{I_1} - \underline{I_2}\right) \cdot \underline{Z_0} - \underline{I_2} \cdot \underline{Z_2} = \underline{U_2}$$

$$\underline{I_1} \cdot \underline{Z_1} + \underline{I_2} \cdot \underline{Z_2} = \underline{U_1} - \underline{U_2}$$

In allgemeiner Form können diese Gleichungen formuliert werden als

$$\underline{A}(t) \cdot \underline{z} = \underline{b}(t)$$

bzw.

$$\underline{A}(t) \cdot \underline{z} - \underline{b}(t) = 0,$$

wobei A(t) eine Matrix ist, deren Matrixelemente von den Strommessungen der eingangsseitigen und ausgangsseitigen Ströme abhängen, z der Vektor der gesuchten Parameter ist und b(t) ein Vektor ist, der von den Spannungsmessungen der eingangsseitigen und ausgangsseitigen Spannungen abhängt.

Die beste Schätzung für die Parameter ist somit der Vektor z, für den die Summe der Abweichungen der berechneten Werte von den gemessenen Werten minimal wird.

Damit ergibt sich folgende Zielfunktion:

$$\sum \left| \underline{A}(t) \cdot \underline{z} - \underline{b}(t) \right|^2 \to Min$$

für alle Messungen t. Das Minimierungsproblem dieser Zielfunktion lässt sich mit Hilfe einer Evolutionsstrategie lösen. Die Idee der Evolutionsstrategien ist es, einen Satz gegebener Lösungen leicht zu modifizieren, unter den so entstandenen neuen Lösungen, die besten auszuwählen und als Ausgangslösungen für neue Modifikationen zu nehmen. Dieser Prozess setzt sich so lange fort, bis er das Optimum des technischen oder mathematischen Problems findet. Dabei orientiert sich das Lösungsverfahren sehr stark an dem Vorbild des natürlichen Evolutionsprozesses.

Für den computerbasierten Einsatz werden die Lösungen des Optimierungsproblems durch reellwertige Vektoren repräsentiert. Der Evolutionsprozess beginnt bei einer Anfangsgeneration von Lösungen, die aus einer Anzahl von Vektoren besteht, den sogenannten "Eltern".

Im ersten Schritt, der Rekombination, werden die genetischen Informationen zweier oder mehrerer Eltern miteinander kombiniert. Dies kann z.B. durch eine Mittelung der beteiligten Elternvektoren geschehen oder durch stückweise Rekombination der Elterngene. Der Rekombination folgt die Mutation, bei der die einzelnen Gene der Rekombinanten leicht modifiziert werden. Nach der Generierung der für eine Population erforderlichen Anzahl an sogenannten "Kindern" wird jeder Lösungsvektor mit Hilfe einer Qualitätsfunktion bewertet, die im Allgemeinen mit der Zielfunktion übereinstimmt. Die im Sinne der Qualitätsfunktion besten Kinder der aktuellen Generation werden zu den Eltern der nächsten Generation bestimmt. Der Evolutionsprozess setzt sich so lange fort, bis ein Abbruchkriterium erfüllt ist. Dies kann z.B. das Erreichen einer maximalen Anzahl von Generationen sein oder das Unterschreiten einer vorgegebenen Mindestverbesserung der letzten Generation. Die sich ergebenden Parameter der Primärkomponente werden mit einem den Zeitpunkt der Messung angebenden Zeitstempel versehen und in einem Datenspeicher abgelegt.

Evolutionsstrategien bieten den Vorteil, dass sie an die mathematischen Eigenschaften der Optimierungsprobleme kaum Anforderungen stellen. So ist z.B. eine geschlossene Formulierung des Optimierungsproblems nicht erforderlich. Damit ist es möglich, den Algorithmus der Evolutionsstrategien von der Berechnung der Qualität des Individuums zu trennen. Im vorliegenden Fall der Figur 2 kann somit eine direkte Formulierung der Gleichungen des T-Ersatzschaltbildes genutzt werden.

Das Verfahren kann kontinuierlich durchgeführt oder in gewissen Zeitabständen wiederholt werden, um die Entwicklung der Parameter über einen längeren Zeitraum beobachten zu können. Dabei können je nach Belastung und äußeren Beeinflussungen der Primärkomponente schleichende und/oder sprunghafte Veränderungen der Parameter auftreten. Durch Beobachtung und Auswertung etwaiger Veränderungen kann auf einen Alterungszustand der Primärkomponente geschlossen werden. Dazu können beispielsweise Schwellen festgelegt werden, ab deren Überschreitung eine Wartungs- oder eine Austauschmaßnahme hinsichtlich der Primärkomponente stattfinden soll.

Beispielhaft für einen Transformator mit einem T-Ersatzschaltbild gemäß Figur 2 wird nachfolgend unter Hinzunahme der Figur 3 ein Ausführungsbeispiel eines Verfahrens zur Ermittlung der Parameter des Transformators beschrieben. Das Beispiel kann entsprechend auf andere Primärkomponenten übertragen werden.

Zunächst werden in einem ersten Schritt 30 Startwerte als Initiallösung für Parameter des Ersatzschaltbildes erzeugt. Diese können zum Beispiel die Typschilddaten im Auslieferungszustand des Transformators sein. Als weiterer Bestandteil des ersten Schritts 30 wird eine Anfangspopulation für die Evolutionsstrategien durch Multiplikation der Komponenten mit Zufallszahlen zwischen Null und Eins erzeugt, um eine gemischte Population zu erhalten.

Diese Anfangspopulation (Startwerte) wird der Evolutionsstrategie übergeben. Diese erzeugt eine Menge abgeleiteter Werte der Parameter, indem sie die Startwerte rekombiniert (Schritt 31) bzw. mutiert (Schritt 32).

Die so erzeugte Menge an abgeleiteten Werten der Parameter (Kinderlösungen) werden an einen folgenden Schritt 33 zur Berechnung der Modellbeschreibung des Ersatzschaltbildes übergeben, um den Wert der Zielfunktion auszurechnen. Der resultierende Wert der Zielfunktion wird entsprechend skaliert und stellt die Qualität bzw. Güte des Individuums im Sinne der Evolutionsstrategie dar.

In einem nächsten Schritt 34 wird geprüft, ob die Menge an abgeleiteten Werten eine Mindestanzahl überschreitet. Ist dies nicht der Fall, werden die Verfahrensschritte 31 bis 33 entsprechend wiederholt, bis die Mindestanzahl von Kinderlösungen erreicht ist.

Nachdem die erforderliche Anzahl an Kinder erzeugt und bewertet wurde, werden in einem folgenden Schritt 35 die besten Kinder selektiert und zu den Eltern der nächsten Generation erklärt. Dabei wird aus der Menge an abgeleiteten Werten eine Untermenge mit der besten Güte im Sinne der zu erfüllenden Zielfunktion ausgewählt. Sofern noch kein Abbruchkriterium erfüllt ist (Schritt 36) werden diese abgeleiteten Werte der Untermenge daraufhin bei Schritt 31 als Eingangswerte für einen erneuten Durchlauf des Evolutionsalgorithmus verwendet.

Der beschriebene Vorgang wiederholt sich so lange, bis in Schritt 36 der Evolutionsprozess ein Abbruchkriterium erfüllt ist. Dies kann beispielsweise nach Durchlauf einer vorgegebenen Anzahl von Iterationen gegeben sein, oder wenn die Güte der Ergebnisse für eine vordefinierte Anzahl von Generationen stagniert und keine besseren Lösungen gefunden werden.

Nach Abschluss der Evolutionsstrategie liegt dann bei Schritt 37 ein Parametersatz für z vor, der eine optimale Schätzung der Parameter des Transformators darstellt.

Diese Vorgehensweise kann in entsprechender Weise auch auf andere Primärkomponenten als Transformatoren angewendet werden. Dabei sind entsprechende Ersatzschaltbilder und Modellbeschreibungen zu verwenden. Durch die Trennung von Problemformulierung gelten die oben gemachten Ausführungen nämlich auch für Primärkomponenten, die durch andere Ersatzschaltbilder als T-Ersatzschaltbilder beschrieben werden.

Ein besonderer Vorteil der oben beschriebenen Lösung liegt in der Trennung von Optimierungsverfahren einerseits und Problemformulierung andererseits. Damit kann das Verfahren sehr einfach für unterschiedliche Primärkomponenten genutzt werden. Dies gilt selbst dann, wenn die Ersatzschaltbilder der Primärkomponente nachträglich geändert oder ergänzt werden. Aufgrund der Eigenschaften der Evolutionsstrategien können auch die Parameter von Primärkomponenten identifiziert werden, deren Zusammenhänge nicht-linear sind und deren Zielfunktionen nicht-konvex sind.

In speziellen Realisierungen des Verfahrens kann die Implementierung so erfolgen, dass die Ausprägungen der einzelnen Typen von Primärkomponenten als separate Module entwickelt werden, die von dem Kernalgorithmus einer Assetmanagementsoftware aufgerufen werden. Dies erhöht die Flexibilität des Verfahrens und reduziert die Entwicklungs- und Pflegekosten der Software.

Obwohl die Erfindung vorstehend im Detail durch bevorzugte Ausführungsbeispiele näher illustriert und beschrieben worden ist, ist die Erfindung nicht durch die offenbarten Beispiele eingeschränkt.

**Patentansprüche**

1.  Verfahren zur Ermittlung von Parametern einer Primärkomponente (11) eines elektrischen Energieversorgungsnetzes, wobei die Parameter elektrische und/oder physikalische Eigenschaften der Primärkomponente (11) angeben und bei dem Verfahren folgende Schritte durchgeführt werden:

    - Erfassen von eingangsseitigen Strom- und Spannungswerten am Eingang der Primärkomponente (11);
    - Erfassen von ausgangsseitigen Strom- und Spannungswerten am Ausgang der Primärkomponente (11); und
    - Ermitteln der Parameter anhand der eingangsseitigen und der ausgangsseitigen Strom- und Spannungswerte und einer für die Primärkomponente (11) spezifischen Modellbeschreibung, die unter Verwendung der Parameter der Primärkomponente (11) mathematisch eine Abhängigkeit der ausgangsseitigen Strom- und Spannungswerte von den eingangsseitigen Strom- und Spannungswerten beschreibt;

    wobei

    - die folgenden weiteren Schritte durchgeführt werden:

        a) Startwerte der Parameter werden als Eingangswerte zur Ermittlung einer Menge von abgeleiteten Werten der Parameter verwendet, wobei als Startwerte solche Werte der Parameter verwendet werden, die elektrische Eigenschaften der Primärkomponente in einem unbenutzten Zustand oder in einem benutzten Zustand angeben;
        b) unter Verwendung der eingangsseitigen und der ausgangsseitigen Strom- und Spannungswerte wird aus der Menge von abgeleiteten Werten der Parameter eine Untermenge solcher abgeleiteter Werte der Parameter ausgesucht, mit denen die Modellbeschreibung mit einer hohen Güte die Abhängigkeit der ausgangsseitigen Strom- und Spannungswerte von den eingangsseitigen Strom- und Spannungswerten beschreibt;

c) unter Verwendung der Untermenge der abgeleiteten Werte der Parameter als Eingangswerte wird eine neue Menge von abgeleiteten Werten der Parameter ermittelt;

d) unter Verwendung der neuen Menge von abgeleiteten Werten der Parameter werden die Schritte b) und c) so lange durchgeführt, bis ein Abbruchkriterium hinsichtlich der Güte der ermittelten abgeleiteten Werte der Parameter erfüllt ist, **dadurch gekennzeichnet, dass**

zur Ermittlung der abgeleiteten Werte der Parameter eine Rekombination und/oder Mutation der jeweiligen Eingangswerte unter Anwendung einer Optimierung mittels einer Evolutionsstrategie durchgeführt wird.

2. Verfahren nach Anspruch 1,
**dadurch gekennzeichnet, dass**

- zur Ermittlung der Untermenge der abgeleiteten Werte der Parameter diejenigen abgeleiteten Werte der Parameter ausgewählt werden, für die eine Differenz zwischen mittels der Modellbeschreibung aus den eingangsseitigen Strom- und Spannungswerten berechneten ausgangsseitigen Strom- und Spannungswerten und den durch Messung erfassten ausgangsseitigen Strom- und Spannungswerten einen ersten Schwellenwert unterschreitet.

3. Verfahren nach Anspruch 1 oder 2,
**dadurch gekennzeichnet, dass**

- das Abbruchkriterium entweder nach Durchlauf einer vorgegebenen Anzahl von Iterationen der Schritte b) und c) oder für solche Werte von Parametern erfüllt ist, für die eine Verbesserung der Güte der aktuellen abgeleiteten Werte der Parameter bezüglich der Güte der vorherigen Werte von Parametern einen zweiten Schwellenwert unterschreitet.

4. Verfahren nach einem der vorangehenden Ansprüche,
**dadurch gekennzeichnet, dass**

- das Verfahren für eine Vielzahl von eingangsseitigen und ausgangsseitigen Strom- und Spannungswerten durchgeführt wird; und
- als Parameter der Primärkomponente (11) solche Parameter verwendet werden, bei denen das Abbruchkriterium unter Betrachtung aller eingangsseitiger und ausgangsseitiger Strom- und Spannungswerte erfüllt ist.

5. Verfahren nach einem der vorangehenden Ansprüche,
**dadurch gekennzeichnet, dass**

- das Verfahren wiederholt durchgeführt wird und ein Verlauf der ermittelten Parameter der Primärkomponente (11) zur Ermittlung eines Alterungszustands der Primärkomponente (11) betrachtet wird.

6. Vorrichtung (13) zur Ermittlung von Parametern einer Primärkomponente (11) eines elektrischen Energieversorgungsnetzes, wobei die Parameter elektrische und/oder physikalische Eigenschaften der Primärkomponente (11) angeben und wobei die Vorrichtung (13) zur Durchführung der folgenden Schritte ausgebildet ist

- Erfassen von eingangsseitigen Strom- und Spannungswerten am Eingang der Primärkomponente (11);
- Erfassen von ausgangsseitigen Strom- und Spannungswerten am Ausgang der Primärkomponente (11); und
- Ermitteln der Parameter anhand der eingangsseitigen und der ausgangsseitigen Strom- und Spannungswerte und einer für die Primärkomponente (11) spezifischen Modellbeschreibung, die unter Verwendung der Parameter der Primärkomponente (11) mathematisch eine Abhängigkeit der ausgangsseitigen Strom- und Spannungswerte von den eingangsseitigen Strom- und Spannungswerten beschreibt;

wobei

- die Vorrichtung (13) zur Durchführung der folgenden weiteren Schritte ausgebildet ist:

a) Startwerte der Parameter werden als Eingangswerte zur Ermittlung einer Menge von abgeleiteten Werten der Parameter verwendet, wobei als Startwerte solche Werte der Parameter verwendet werden, die elektrische Eigenschaften der Primärkomponente in einem unbenutzten Zustand oder in einem benutzten Zustand angeben;

b) unter Verwendung der eingangsseitigen und der ausgangsseitigen Strom- und Spannungswerte wird aus der Menge von abgeleiteten Werten der Parameter eine Untermenge solcher abgeleiteter Werte der Parameter ausgesucht, mit denen die Modellbeschreibung mit einer hohen Güte die Abhängigkeit der ausgangsseitigen Strom- und Spannungswerte von den eingangsseitigen Strom- und Spannungswerten beschreibt;

c) unter Verwendung der Untermenge der abgeleiteten Werte der Parameter als Eingangswerte wird eine neue Menge von abgeleiteten Werten der Parameter ermittelt;

d) unter Verwendung der neuen Menge von abgeleiteten Werten der Parameter werden die Schritte b) und c) so lange durchgeführt, bis ein Abbruchkriterium hinsichtlich der Güte der ermittelten abgeleiteten Werte der Parameter erfüllt ist, **dadurch gekennzeichnet, dass**

zur Ermittlung der abgeleiteten Werte der Parameter eine Rekombination und/oder Mutation der jeweiligen Eingangswerte unter Anwendung einer Optimierung mittels einer Evolutionsstrategie durchgeführt wird.

## Claims

1. Method for determining parameters of a primary component (11) of an electrical energy supply grid, wherein the parameters specify electrical and/or physical properties of the primary component (11) and in which method the following steps are carried out:

   - recording input-side current and voltage values at the input of the primary component (11);
   - recording output-side current and voltage values at the output of the primary component (11); and
   - determining the parameters on the basis of the input-side and the output-side current and voltage values and a model description that is specific to the primary component (11) and mathematically describes a dependency of the output-side current and voltage values on the input-side current and voltage values using the parameters of the primary component (11) ;

   wherein

   - the following further steps are carried out:

   a) starting values of the parameters are used as input values for determining a set of derived values of the parameters, wherein the values of the parameters used as the starting values are those that specify electrical properties of the primary component in an unused state or in a used state;

   b) using the input-side and the output-side current and voltage values, a subset of derived values of the parameters, which are used by the model description to describe the dependency of the output-side current and voltage values on the input-side current and voltage values with high quality, is chosen from the set of derived values of the parameters;

   c) a new set of derived values of the parameters is determined using the subset of derived values of the parameters as input values;

   d) using the new set of derived values of the parameters, steps b) and c) are carried out until an abort criterion in respect of the quality of the determined derived values of the parameters has been met,

   **characterized in that**
   recombination and/or mutation of the respective input values is carried out using an optimization by means of an evolution strategy in order to determine the derived values of the parameters.

2. Method according to Claim 1,
   **characterized in that**,

   - in order to determine the subset of derived values of the parameters, those derived values of the parameters are selected for which a difference between output-side current and voltage values, calculated from the input-side current and voltage values by means of the model description, and the output-side current and voltage values recorded by measurement falls below a first threshold value.

3. Method according to Claim 1 or 2,
   **characterized in that**

   - the abort criterion is met either after a predefined number of iterations of steps b) and c) have been run through or for those values of parameters for which an improvement in the quality of the present derived values of the parameters relative to the quality of the previous values of parameters falls below a second threshold value.

4. Method according to one of the preceding claims,
   **characterized in that**

   - the method is carried out for a plurality of input-side and output-side current and voltage values; and
   - the parameters used as the parameters of the primary component (11) are those for which the abort criterion is met, taking into consideration all of the input-side and output-side current and voltage values.

5. Method according to one of the preceding claims, **characterized in that**

- the method is carried out repeatedly and a profile of the determined parameters of the primary component (11) is observed to determine a state of health of the primary component (11).

6. Device (13) for determining parameters of a primary component (11) of an electrical energy supply grid, wherein the parameters specify electrical and/or physical properties of the primary component (11), and wherein the device (13) is designed to carry out the following steps:

- recording input-side current and voltage values at the input of the primary component (11);
- recording output-side current and voltage values at the output of the primary component (11); and
- determining the parameters on the basis of the input-side and the output-side current and voltage values and a model description that is specific to the primary component (11) and mathematically describes a dependency of the output-side current and voltage values on the input-side current and voltage values using the parameters of the primary component (11) ;

wherein

- the device (13) is designed to carry out the following further steps:

a) starting values of the parameters are used as input values for determining a set of derived values of the parameters, wherein the values of the parameters used as the starting values are those that specify electrical properties of the primary component in an unused state or in a used state;
b) using the input-side and the output-side current and voltage values, a subset of derived values of the parameters, which are used by the model description to describe the dependency of the output-side current and voltage values on the input-side current and voltage values with high quality, is chosen from the set of derived values of the parameters;
c) a new set of derived values of the parameters is determined using the subset of derived values of the parameters as input values;

d) using the new set of derived values of the parameters, steps b) and c) are carried out until an abort criterion in respect of the quality of the determined derived values of the parameters has been met,

**characterized in that**
recombination and/or mutation of the respective input values is carried out using an optimization by means of an evolution strategy in order to determine the derived values of the parameters.

**Revendications**

1. Procédé de détermination de paramètres d'un composant (11) primaire d'un réseau d'alimentation en énergie électrique, dans lequel les paramètres indiquent des propriétés électriques et/ou physiques du composant (11) primaire et, dans le procédé, on effectue les stades suivants :

- le relevé de valeurs de courant et de tension du côté de l'entrée, à l'entrée du composant (11) primaire ;
- le relevé de valeurs de courant et de tension du côté de la sortie, à la sortie du composant (11) primaire ; et
- la détermination des paramètres, à l'aide des valeurs de courant et de tension du côté de l'entrée et du côté de la sortie et d'une description de modèle spécifique au composant (11) primaire,
qui décrit, en utilisant les paramètres du composant (11) primaire, mathématiquement une variation des valeurs de courant et de tension du côté de la sortie, en fonction des valeurs de courant et de tension du côté de l'entrée ;
dans lequel

- on effectue les autres stades suivants :

a) on utilise des valeurs de début des paramètres comme valeurs d'entrée pour la détermination d'un ensemble de valeurs dérivées des paramètres, en utilisant comme valeurs de début des valeurs des paramètres, qui indiquent les propriétés électriques du composant primaire dans un état inutilisé ou dans un état utilisé ;
b) en utilisant les valeurs de courant et de tension du côté de l'entrée et du côté de la sortie, on recherche dans l'ensemble de valeurs dérivées des paramètres un sous-ensemble de valeurs dérivées des paramètres, par lesquelles la description du modèle décrit avec une grande qualité la variation des valeurs de courant et de tension du côté de la sortie en fonction des valeurs de courant et de tension du côté de l'entrée ;

c) en utilisant le sous-ensemble des valeurs dérivées des paramètres, on détermine comme valeurs d'entrée, un nouvel ensemble de valeurs dérivées des paramètres ;

d) en utilisant le nouvel ensemble de valeurs dérivées des paramètres, on effectue les stades b) et c) jusqu'à ce qu'un critère de rupture en ce qui concerne la qualité des valeurs dérivées déterminées des paramètres soit satisfait,

**caractérisé en ce que**

pour la détermination des valeurs dérivées des paramètres, on effectue une recombinaison et/ou une mutation des valeurs d'entrée respectives en utilisant une optimisation au moyen d'une stratégie d'évolution.

**2.** Procédé suivant la revendication 1,
**caractérisé en ce que**

- pour la détermination des sous-ensembles des valeurs dérivées des paramètres, on choisit les valeurs dérivées des paramètres pour lesquelles une différence entre des valeurs de courant et de tension du côté de la sortie, calculées à partir des valeurs de courant et de tension du côté de l'entrée au moyen de la description par le modèle, et les valeurs de courant et de tension du côté de la sortie relevées par une mesure, est inférieure à une valeur de seuil.

**3.** Procédé suivant la revendication 1 ou 2,
**caractérisé**

- **en ce que** le critère de rupture est satisfait soit après avoir effectué un nombre donné à l'avance d'itérations des stades b) et c) ou pour des valeurs de paramètres, pour lesquelles une amélioration de la qualité des valeurs déduites en cours des paramètres, par rapport à la qualité des valeurs précédentes de paramètres, est inférieure à une deuxième valeur de seuil.

**4.** Procédé suivant l'une des revendications précédentes, **caractérisé en ce que**

- on effectue le procédé pour une pluralité de valeurs de courant et de tension du côté de l'entrée et du côté de la sortie ; et
- on utilise, comme paramètres du composant (11) primaire, les paramètres pour lesquels le critère de rupture est satisfait, en prenant en considération toutes les valeurs de courant et de tension du côté de l'entrée et du côté de la sortie.

**5.** Procédé suivant l'une des revendications précédentes,
**caractérisé en ce que**

- on effectue de manière répétée le procédé et on considère une courbe des paramètres déterminés du composant (11) primaire pour la détermination d'un état de vieillissement du composant (11) primaire.

**6.** Dispositif (13) de détermination de paramètres d'un composant (11) primaire d'un réseau d'alimentation en énergie électrique, dans lequel les paramètres indiquent des propriétés électriques et/ou physiques du composant (11) primaire, et dans lequel le dispositif (13) est constitué pour effectuer les stades suivants :

- le relevé de valeurs de courant et de tension du côté de l'entrée, à l'entrée du composant (11) primaire ;
- le relevé de valeurs de courant et de tension du côté de la sortie, à la sortie du composant (11) primaire ; et
- la détermination des paramètres, à l'aide des valeurs de courant et de tension du côté de l'entrée et du côté de la sortie et d'une description de modèle spécifique au composant (11) primaire,

qui décrit, en utilisant les paramètres du composant (11) primaire, mathématiquement une variation des valeurs de courant et de tension du côté de la sortie, en fonction des valeurs de courant et de tension du côté de l'entrée ;
dans lequel

- le dispositif (13) est constitué pour effectuer les autres stades suivants :

a) on utilise des valeurs de début des paramètres comme valeurs d'entrée pour la détermination d'un ensemble de valeurs dérivées des paramètres, en utilisant comme valeurs de début des valeurs des paramètres, qui indiquent les propriétés électriques du composant primaire dans un état inutilisé ou dans un état utilisé ;

b) en utilisant les valeurs de courant et de tension du côté de l'entrée et du côté de la sortie, on recherche dans l'ensemble de valeurs dérivées des paramètres un sous-ensemble de valeurs dérivées des paramètres, par lesquelles la description du modèle décrit avec une grande qualité la variation des valeurs de courant et de tension du côté de la sortie en fonction des valeurs de courant et de tension du côté de l'entrée ;

c) en utilisant le sous-ensemble des valeurs dérivées des paramètres, on détermine comme valeurs d'entrée, un nouvel ensemble de valeurs dérivées des paramètres ;

d) en utilisant le nouvel ensemble de valeurs dérivées des paramètres, on effectue les stades b) et c) jusqu'à ce qu'un critère de rupture en ce qui concerne la qualité des valeurs dérivées déterminées des paramètres soit satisfait,

**caractérisé en ce que**
pour la détermination des valeurs dérivées des paramètres, on effectue une recombinaison et/ou une mutation des valeurs d'entrée respectives en utilisant une optimisation au moyen d'une stratégie d'évolution.

## FIG 1

13

12a

10

11

12b

## FIG 2

I1

U1

Z1

Z0

Z2

I2

U2

20

# FIG 3

```
┌─────────────────────────────┐
│      Initialisierung        │──── 30
└─────────────────────────────┘
              │
              ▼
┌─────────────────────────────┐
│       Rekombination         │──── 31
└─────────────────────────────┘
              │
              ▼
┌─────────────────────────────┐
│         Mutation            │──── 32
└─────────────────────────────┘
              │
              ▼
┌─────────────────────────────┐
│      Qualitätsermittlung    │──── 33
└─────────────────────────────┘
              │
              ▼
        ◇ Anzahl Kinder
   nein ◇   erreicht ?  ◇──── 34
              │ ja
              ▼
┌─────────────────────────────┐
│         Selektion           │──── 35
└─────────────────────────────┘
              │
              ▼
        ◇ Abbruchkriterium
   nein ◇    erfüllt ?   ◇──── 36
              │ ja
              ▼
┌─────────────────────────────┐
│   Parameter identifiziert   │──── 37
└─────────────────────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1623240 A2
- WO 2012162486 A2
- DE 10253865 A1